# EUROPÄISCHE PATENTANMELDUNG

(11) **EP 3 772 083 A1**
(43) Veröffentlichungstag der Anmeldung: **03.02.2021**
(21) Anmeldenummer: 20183344.9
(22) Anmeldetag: 01.07.2020
(51) Int. Cl.: H01H 71/04, H01H 71/46, B61L 15/00, B61L 27/00

(54) **ÜBERWACHUNGSSYSTEM UND VERFAHREN**

(30) Priorität: 30.07.2019 DE 102019120569
(71) Anmelder: Schunk Transit Systems GmbH, 35435 Wettenberg (DE)
(72) Erfinder: FLEISCHHAUER, Guntram, 35102 Lohra (DE)
(74) Vertreter: advotec.

(57) **Zusammenfassung**

Die Erfindung betrifft ein Überwachungssystem und ein Verfahren zur Überwachung von zumindest einer Hochspannungs-Sicherung eines Sicherungskastens eines elektrisch angetriebenen Schienenfahrzeugs eines Überwachungssystems, wobei das Überwachungssystem ein elektrisch angetriebenes Schienenfahrzeug mit einem Sicherungskasten (10) mit zumindest einer Hochspannungs-Sicherung (11, 12) umfasst, wobei der Sicherungskasten ein gegenüber einer Umgebung geschlossenes Gehäuse (13) mit zumindest zwei Kabeleinführungen (14, 15, 16) aufweist, wobei durch die Kabeleinführungen verlaufende Hochspannungskabel des Schienenfahrzeuges mit der Sicherung verbunden sind, wobei das Schienenfahrzeug zumindest einen passiven RFID-Transponder aufweist, wobei mittels des RFID-Transponders ein Status der Sicherung an eine Sender-Empfänger-Einheit übermittelbar ist, wobei die Sender-Empfänger-Einheit in einem Wartungsbereich zur Wartung des Schienenfahrzeugs ortsfest angeordnet ist.

## Beschreibung

Die Erfindung betrifft ein Überwachungssystem sowie ein Verfahren zur Überwachung von zumindest einer Hochspannungs-Sicherung eines Sicherungskastens eines elektrisch angetriebenen Schienenfahrzeugs eines Überwachungssystems, wobei das Überwachungssystem ein elektrisch angetriebenes Schienenfahrzeug mit einem Sicherungskasten mit zumindest einer Hochspannungs-Sicherung umfasst, wobei der Sicherungskasten ein gegenüber einer Umgebung geschlossenes Gehäuse mit zumindest zwei Kabeleinführungen aufweist, wobei durch die Kabeleinführungen verlaufende Hochspannungskabel des Schienenfahrzeugs mit der Sicherung verbunden sind.

Überwachungssysteme der eingangs bezeichneten Art sind aus dem Stand der Technik hinlänglich bekannt und werden regelmäßig zur Überwachung von zumindest einer Hochspannungs-Sicherung eines Sicherungskastens eines elektrisch angetriebenen Schienenfahrzeugs, insbesondere einer Eisenbahn, Straßenbahn, Untergrundbahn, Schwebebahn oder dergleichen, eingesetzt. Oftmals ist als Sicherung ein Leitungsschutzschalter mit einem Stift vorgesehen, welcher in einer Richtung einer Längsachse des Stifts derart bewegbar ausgebildet ist, dass ein Status der Sicherung durch eine Position einer Oberseite des Stiftes relativ zu einer Oberseite eines Gehäuses der Sicherung anzeigbar ist. Ist ein Verbraucherstromkreis zur Versorgung von elektrischen Verbrauchern des Schienenfahrzeugs mit elektrischer Energie mittels der Sicherung bzw. des Leitungsschutzschalters geschlossen, so kann die Oberseite des Stiftes mit der Oberseite des Gehäuses der Sicherung bündig abschließen. Löst die Sicherung nun aus bzw. wird der Verbraucherstromkreis nun unterbrochen, bewegt sich der Stift in der Richtung der Längsachse derart, dass er nach dem Auslösen in einer Position zur Ruhe kommt, in welcher die Oberseite des Stiftes relativ zu der Oberseite des Gehäuses der Sicherung beabstandet ist.

Um den Status der Sicherung bzw. die Position der Oberseite des Stiftes relativ zu der Oberseite des Gehäuses der Sicherung überwachen zu können, weist ein gegenüber einer Umgebung geschlossenes Gehäuse des Sicherungskastens regelmäßig in einer Oberseite des Gehäuses ein Kontrollfenster auf, welches eine visuelle Kontrolle des Status der Sicherung bzw. der Position des Stiftes erlaubt. Nachteilig ist hier jedoch, dass die Kontrolle aufgrund einer Verschmutzung des Kontrollfensters häufig nur schwerlich durchgeführt werden kann. Das Kontrollfenster kann sogar derart beschmutzt sein, dass eine visuelle Kontrolle des Status durch das Kontrollfenster hindurch unmöglich ist. In einem solchen Fall muss die Oberseite des Gehäuses des Sicherungskastens entfernt werden, um die Kontrolle des Status vornehmen zu können, was sehr aufwändig ist.

Weiter ist aus dem Stand der Technik bekannt, den Leitungsschutzschalter mit einem in dem Sicherungskasten sitzenden Schalter eines Auswertestromkreises, der über eine zusätzliche Energiequelle mit elektrischer Energie gespeist wird, mechanisch zu koppeln. Löst die Sicherung bzw. der Leitungsschutzschalter nun aus, betätigt der sich bewegende Stift den Schalter, wodurch der Auswertestromkreis geschlossen wird, so dass eine in den Auswertestromkreis integrierte Anzeigeeinheit, wie beispielsweise eine LED, das Auslösen der Sicherung bzw. des Leitungsschutzschalters anzeigt. Da der Auswertestromkreis in einem Niederspannungsbereich betrieben wird, kann es zu elektrischen Überschlägen zwischen in den Sicherungskasten eingeführten Niederspannungskabeln des Auswertestromkreises und den mit der Sicherung verbundenen Hochspannungskabeln kommen, was sich ungünstig auf eine Betriebssicherheit des Sicherungskastens bzw. des Überwachungssystems auswirkt. Zudem erhöht eine Verwendung eines derartigen Auswertestromkreises eine Komplexität einer Infrastruktur des Schienenfahrzeugs, was mit erhöhten Herstellungs- und Betriebskosten verbunden ist.

Der vorliegenden Erfindung liegt daher die Aufgabe zugrunde, ein Überwachungssystem sowie ein Verfahren zur Überwachung von zumindest einer Hochspannungs-Sicherung eines Sicherungskastens eines elektrisch angetriebenen Schienenfahrzeugs eines Überwachungssystems vorzuschlagen, das eine einfache und sichere Überwachung ermöglicht.

Diese Aufgabe wird durch ein Überwachungssystem mit den Merkmalen des Anspruchs 1 und ein Verfahren mit den Merkmalen des Anspruchs 17 gelöst.

Das erfindungsgemäße Überwachungssystem umfasst ein elektrisch angetriebenes Schienenfahrzeug mit einem Sicherungskasten mit zumindest einer Hochspannungs-Sicherung, wobei der Sicherungskasten ein gegenüber einer Umgebung geschlossenes Gehäuse mit zumindest zwei Kabeleinführungen aufweist, wobei durch die Kabeleinführungen verlaufende Hochspannungskabel des Schienenfahrzeugs mit der Sicherung verbunden sind, wobei das Schienenfahrzeug zumindest einen passiven RFID-Transponder aufweist, wobei mittels des RFID-Transponders ein Status der Sicherung an eine Sender-Empfänger-Einheit übermittelbar ist, wobei die Sender-Empfänger-Einheit in einem Wartungsbereich zur Wartung des Schienenfahrzeugs ortsfest angeordnet ist.

Demzufolge weist das Schienenfahrzeug einen passiven RFID-Transponder auf, mittels dessen der Status der Sicherung an eine Sender-Empfänger-Einheit übermittelt werden kann. Dabei kann die Sender-Empfänger-Einheit ein elektromagnetisches Wechselfeld erzeugen, welches von dem RFID-Transponder empfangen werden kann, wodurch der RFID-Transponder aktiviert und ausgelesen werden kann. Als passiver RFID-Transponder bedarf der RFID-Transponder keiner zusätzlichen Energiequelle, weil eine Versorgung des RFID-Transponders mit elektrischer Energie durch das von der Sender-Empfänger-Einheit erzeugte elektromagnetische Wechselfeld erfolgt. Dadurch kann auf einen Auswertestromkreis mit einer zusätzlichen Energiequelle bzw. in den Sicherungskasten geführte Niederspannungskabel vollständig verzichtet werden, so dass eine Entstehung von elektrischen Überschlägen vermieden werden kann, was zu einer erhöhten Betriebssicherheit des Sicherungskastens bzw. des Überwachungssystems führt.

Auch kann die Überwachung des Status der Sicherung nun wesentlich einfacher durchgeführt werden, da ein verschmutztes Kontrollfenster für einen Wartungstechniker kein Hindernis mehr darstellt und insbesondere eine Oberseite des Gehäuses des Sicherungskastens bei hochgradiger Verschmutzung nicht länger entfernt zu werden braucht.

Weiter kann eine Komplexität einer Infrastruktur des Schienenfahrzeugs durch einen Verzicht auf einen Auswertestromkreis und eine damit verbundene Führung bzw. Verlegung von Niederspannungskabeln beträchtlich reduziert werden. Insgesamt kann somit mit dem erfindungsgemäßen Überwachungssystem eine Überwachung von zumindest einer Hochspannungs-Sicherung eines Sicherungskastens eines elektrisch angetriebenen Schienenfahrzeugs einfacher und sicherer durchgeführt werden.

In einer Ausführungsform der Erfindung kann der RFID-Transponder innerhalb des Gehäuses an der Sicherung angeordnet sein. Dadurch wird ein eigenes Gehäuse für den RFID-Transponder überflüssig, so dass der Sicherungskasten bzw. der RFID-Transponder in dem Schienenfahrzeug platzsparend verbaut werden kann. Auch kann das Überwachungssystem in diesem Fall kostengünstiger hergestellt werden.

In einer alternativen Ausführungsform der Erfindung kann der RFID-Transponder ein gegenüber einer Umgebung geschlossenes Gehäuse aufweisen und neben dem Sicherungskasten angeordnet sein. Dies kann beispielsweise dann vorteilhaft sein, wenn ein aus dem Stand der Technik bekanntes Überwachungssystem mit einem RFID-Transponder nachgerüstet werden soll und ein Gehäuse eines Sicherungskastens dieses Überwachungssystems in einem Innenraum des Gehäuses nicht ausreichend viel Platz bietet, um in demselben nachträglich einen RFID-Transponder einzubauen. Auch kann vorgesehen sein, dass das Gehäuse des Sicherungskastens mit dem Gehäuse des RFID-Transponders beispielsweise mittels Rastnasen verbindbar ist.

Ferner kann das Überwachungssystem die Sender-Empfänger-Einheit umfassen.

Gemäß einer konstruktiv vorteilhaften Ausgestaltung der Erfindung kann der Wartungsbereich außerhalb des Schienenfahrzeugs liegen. Dabei kann der Wartungsbereich eine Wartungshalle, ein Bahnhof oder ein Abstellgleis sein.

Zweckmäßig kann die Sender-Empfänger-Einheit in einem Einfahrtsabschnitt des Wartungsbereiches angeordnet sein. Umfasst das Schienenfahrzeug nun mehrere Einheiten, wie Triebwagen oder Waggons, so können auf einer Länge des Schienenfahrzeugs verteilte RFID-Transponder bei einem Passieren des Einfahrtsabschnitts sukzessive mittels der Sender-Empfänger-Einheit ausgelesen werden, wobei ein Status einer Sicherung an die Sender-Empfänger-Einheit übermittelt wird. Vorzugsweise kann die Sender-Empfänger-Einheit dann benachbart einer Schiene des Wartungsbereichs angeordnet sein, um eine möglichst kurze Distanz zwischen dem RFID-Transponder und der Sender-Empfänger-Einheit und somit eine hohe Auslesegeschwindigkeit zu gewährleisten.

In einer weiteren vorteilhaften Variante der Erfindung kann der Wartungsbereich innerhalb des Schienenfahrzeuges liegen. Auch kann das Überwachungssystem zumindest zwei Sender-Empfänger-Einheiten umfassen, von denen beispielsweise eine innerhalb des Schienenfahrzeugs und eine weitere außerhalb des Schienenfahrzeugs angeordnet sein kann.

In einer besonderen Weiterbildung der Erfindung kann das Überwachungssystem ein mobil handhabbares Anzeigegerät und/oder ein mobil handhabbares Bediengerät umfassen. Dabei kann das Anzeigegerät bzw. das Bediengerät als ein Mobiltelefon oder ein Tablet-Computer ausgeführt sein, welches bzw. welcher über ein drahtloses lokales Netzwerk (WLAN) mit der Sender-Empfänger-Einheit kommunizieren kann. Weiter kann für das Anzeigegerät bzw. Bediengerät eine Überwachungssoftware vorgesehen sein, mittels derer auch ein Status von Sicherungen von einer Mehrzahl von Schienenfahrzeugen überwacht werden kann.

Gemäß einer zweckmäßigen konstruktiven Ausgestaltung der Erfindung können ausschließlich Hochspannungskabel durch die Kabeleinführungen verlaufen. Dadurch kann eine Ausbildung von hohen elektrischen Potentialdifferenzen zwischen allen durch die Kabeleinführungen oder in dem Sicherungskasten verlaufenden Kabeln unterbunden und somit elektrische Überschläge sicher vermieden werden.

Als Sicherung kann ein Leitungsschutzschalter bzw. Sicherungsautomat vorgesehen sein. Unter Leitungsschutzschalter wird hier im Wesentlichen eine Überstrom-Schutzeinrichtung verstanden, die man nach dem Auslösen durch Betätigung eines Schalters wieder einschalten kann. Gleichwohl kann die Sicherung als Leistungsschalter oder Schmelzsicherung ausgeführt sein.

Vorteilhafterweise kann der Leitungsschutzschalter einen Stift aufweisen, welcher in Richtung einer Längsachse des Stifts derart bewegbar ausgebildet sein kann, dass der Status durch eine Position einer Oberseite des Stiftes relativ zu einer Oberseite eines Gehäuses der Sicherung anzeigbar ist. In einem nicht ausgelösten Status der Sicherung kann die Oberseite des Stiftes dann bündig mit der Oberseite des Gehäuses der Sicherung abschließen, in einem ausgelösten Status der Sicherung kann die Oberseite des Stiftes relativ zu der Oberseite des Gehäuses der Sicherung beabstandet sein. Durch ein Betätigen bzw. Drücken des Stiftes in dem ausgelösten Zustand kann die Sicherung dann wieder in den nicht ausgelösten Zustand verbracht werden.

Auch kann das Gehäuse in einer Oberseite ein Kontrollfenster aufweisen, welches eine visuelle Kontrolle des Status erlaubt. Somit kann ein Wartungstechniker den Status der Sicherung, beispielsweise im Fall eines technischen Defekts des RFID-Transponders bzw. der Sender-Empfänger-Einheit, ohne die Oberseite des Gehäuses zu entfernen, unmittelbar einsehen.

Weiter kann eine an den Hochspannungskabeln anlegbare Hochspannung in einem Bereich von 500 bis 2000 V liegen.

Ferner kann eine Auslösestromstärke der Sicherung in einem Bereich von 500 bis 2000 A liegen.

Gemäß einer konstruktiv vorteilhaften Ausgestaltung der Erfindung kann die Sicherung mechanisch mit dem RFID-Transponder gekoppelt sein, wobei die Sicherung einen Kurzschlussbügel aufweisen kann, mittels dessen ein Verbraucherstromkreis zur Versorgung von elektrischen Verbrauchern des Schienenfahrzeugs mit elektrischer Energie und/oder ein Antennenstromkreis zur Versorgung des RFID-Transponders mit elektrischer Energie schließbar ist. Dabei kann der Kurzschlussbügel den Verbraucherstromkreis in einem nicht ausgelösten Status der Sicherung bei offenem Antennenstromkreis schließen. Beim Auslösen der Sicherung kann der Verbraucherstromkreis dann unterbrochen und der Antennenstromkreis geschlossen werden, so dass der RFID-Transponder aktiviert wird und von der Sender-Empfänger-Einheit ausgelesen werden kann. Alternativ können in dem nicht ausgelösten Zustand der Sicherung sowohl der Verbraucherstromkreis als auch der Antennenstromkreis geschlossen sein, wobei im Fall eines Auslösens der Sicherung sowohl der Verbraucherstromkreis als auch der Antennenstromkreis unterbrochen werden, so dass der RFID-Transponder deaktiviert und nun nicht mehr ausgelesen werden kann.

In einer Ausführungsform kann die Sicherung mittels eines Hebelelements mit dem RFID-Transponder gekoppelt sein. Wenn der RFID-Transponder ein gegenüber einer Umgebung geschlossenes Gehäuse aufweist und neben dem Sicherungskasten angeordnet ist, können das Gehäuse des RFID-Transponders und das Gehäuse des Sicherungskastens Öffnungen zum Einführen des Hebelelements aufweisen. Das Hebelelement kann bei einem Auslösen der Sicherung einen Schalter des RFID-Transponders betätigen und dadurch einen Antennenstromkreis zur Versorgung des RFID-Transponders mit elektrischer Energie schließen.

Bei dem erfindungsgemäßen Verfahren zur Überwachung von zumindest einer Hochspannungs-Sicherung eines Sicherungskastens eines elektrisch angetriebenen Schienenfahrzeugs eines Überwachungssystems mittels des Überwachungssystems werden durch zumindest zwei Kabeleinführungen eines gegenüber einer Umgebung geschlossenen Gehäuses des Sicherungskastens verlaufende Hochspannungskabel des Schienenfahrzeugs mit der Sicherung verbunden, wobei mittels zumindest eines passiven RFID-Transponders des Schienenfahrzeugs ein Status der Sicherung an eine Sender-Empfänger-Einheit des Überwachungssystems übermittelt wird, wobei die Sender-Empfänger-Einheit in einem Wartungsbereich zur Wartung des Schienenfahrzeugs ortsfest angeordnet wird. Zu den vorteilhaften Wirkungen des erfindungsgemäßen Verfahrens wird auf die Vorteilsbeschreibung des erfindungsgemäßen Überwachungssystems verwiesen.

Die Sender-Empfänger-Einheit kann ein elektromagnetisches Wechselfeld erzeugen, welches von dem RFID-Transponder empfangen wird, wodurch der RFID-Transponder aktiviert wird. Dabei wird der RFID-Transponder von dem elektromagnetischen Wechselfeld mit elektrischer Energie versorgt und bedarf somit keiner eigenen Energiequelle. Nach der Aktivierung kann ein Speicher bzw. ein Mikrochip des RFID-Transponders ausgelesen werden.

Bevorzugt kann ein hochfrequentes (HF), besonders bevorzugt ein ultrahochfrequentes (UHF) Wechselfeld erzeugt werden. Ultrahochfrequente Wechselfelder haben im Vergleich zu hochfrequenten Wechselfeldern eine größere Reichweite und können somit vornehmlich dann eingesetzt werden, wenn die Sender-Empfänger-Einheit außerhalb des Schienenfahrzeugs angeordnet ist. Ist die Sender-Empfänger-Einheit hingegen innerhalb des Schienenfahrzeugs angeordnet, kann es ausreichend sein, hochfrequente Wechselfelder zu verwenden.

Gemäß einem Ausführungsbeispiel der Erfindung kann mittels eines Anzeigegerätes der Sender-Empfänger-Einheit und/oder des Sicherungskastens der Status angezeigt werden. Das Anzeigegerät kann einen Bildschirm und/oder eine optische und/oder akustische Alarmvorrichtung aufweisen, die einen Wartungstechniker auf eine einfache Weise davon in Kenntnis setzen kann, ob eine und welche Sicherung sich in einem ausgelösten Status befindet.

Vorzugsweise kann das Schienenfahrzeug relativ zu der Sender-Empfänger-Einheit bewegt werden. Dabei kann die Sender-Empfänger-Einheit außerhalb des Schienenfahrzeugs an einem Ort benachbart einer Schiene des Wartungsbereiches angeordnet sein. Das Schienenfahrzeug kann mehrere Einheiten, wie Triebwagen oder Waggons, umfassen. Passieren die Einheiten des Schienenfahrzeugs beim Einfahren in den Wartungsbereich nun den besagten Ort, können über eine Länge des Schienenfahrzeugs bzw. die einzelnen Einheiten verteilte RFID-Transponder nach und nach ausgelesen werden, bis die letzte Einheit den besagten Ort passiert hat. Eine Fahrgeschwindigkeit des Schienenfahrzeugs kann dabei an eine Lesegeschwindigkeit der Sender-Empfänger-Einheit angepasst werden.

In einer besonderen Weiterbildung der Erfindung kann ein Wartungshinweis für die Sicherung übermittelt werden. Ein Wartungstechniker kann so unmittelbar feststellen, ob eine und welche Sicherung ausgetauscht werden muss.

Weitere vorteilhafte Ausführungsformen des Verfahrens ergeben sich aus den Merkmalsbeschreibungen der auf den Vorrichtungsanspruch 1 rückbezogenen Unteransprüche.

Nachfolgend werden bevorzugte Ausführungsformen der Erfindung unter Bezugnahme auf die beigefügten Zeichnungen näher erläutert.

Es zeigen:
- **Fig. 1 - 2**: eine perspektivische Darstellung eines Sicherungskastens;
- **Fig. 3 - 4**: eine Prinzipdarstellung eines Überwachungssystems in einer Ausführungsform;
- **Fig. 5 - 6**: eine Prinzipdarstellung eines Überwachungssystems in einer weiteren Ausführungsform.

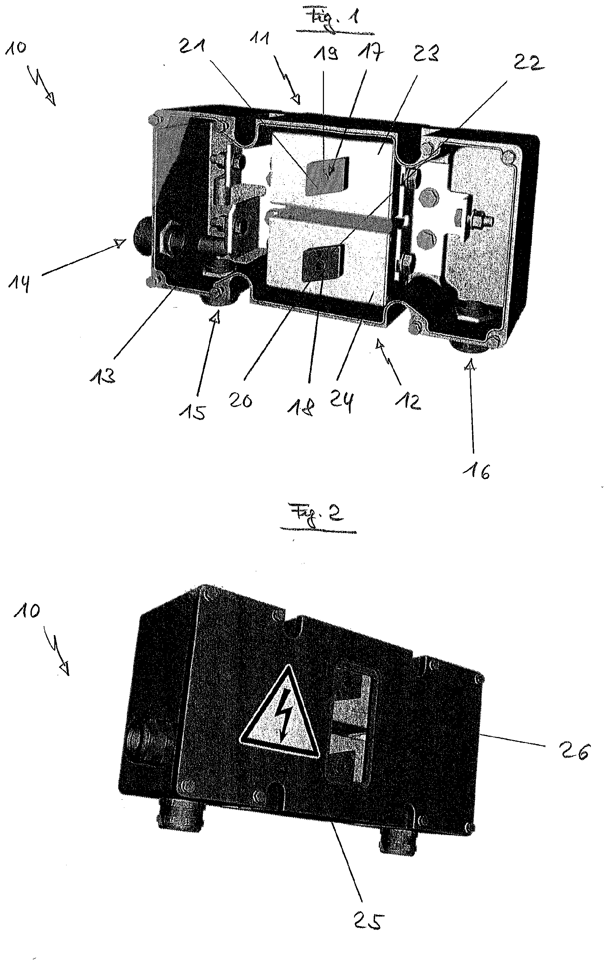

Eine Zusammenschau der **Fig. 1** und **2** zeigt einen Sicherungskasten 10 eines hier nicht gezeigten elektrisch angetriebenen Schienenfahrzeugs eines Überwachungssystems, welcher zwei Hochspannungs-Sicherungen 11 und 12 aufweist, welche in einem gegenüber einer Umgebung geschlossenen Gehäuse 13 des Sicherungskastens 10 angeordnet sind. Dabei weist das Gehäuse 13 Kabeleinführungen 14, 15 und 16 auf, durch welche hier nicht gezeigte Hochspannungskabel des Schienenfahrzeugs geführt und mit den Sicherungen 11 und 12 verbunden werden können. Die Sicherungen 11 und 12 sind hier jeweils durch einen Leitungsschutzschalter ausgebildet, welcher einen Stift 17 bzw. 18 aufweist, welcher in Richtung einer hier nicht gezeigten Längsachse des Stifts 17 bzw. 18 derart bewegbar ausgebildet ist, dass ein Status der Sicherung 11 bzw. 12 durch eine Position einer Oberseite 19 bzw. 20 des Stifts 17 bzw. 18 relativ zu einer Oberseite 21 bzw. 22 eines Gehäuses 23 bzw. 24 der Sicherung 11 bzw. 12 anzeigbar ist.

In den **Fig. 1** und **2** befinden sich die Sicherungen 11 bzw. 12 in einem nicht ausgelösten Status, was dadurch angezeigt wird, dass die Oberseite 19 bzw. 20 des Stifts 17 bzw. 18 bündig mit der Oberseite 21 bzw. 22 des Gehäuses 23 bzw. 24 der Sicherung 11 bzw. 12 abschließt. Wird die Sicherung 11 bzw. 12 nun ausgelöst, beispielsweise bedingt dadurch, dass eine Stromstärke eines durch die Hochspannungskabel fließenden Stroms eine definierte Auslösestromstärke überschreitet, wird der Stift 17 bzw. 18 um einige Millimeter in der Richtung der Längsachse bewegt, so dass die Oberseite 19 bzw. 20 in einem ausgelösten Status der Sicherung 11 bzw. 12 relativ von der Oberseite 21 bzw. 22 beabstandet ist. Durch Betätigung bzw. Hereindrücken des Stiftes 17 bzw. 18 kann die Sicherung 11 bzw. 12 nach dem Auslösen wieder von dem ausgelösten Status in den nicht ausgelösten Status verbracht werden. Weiter weist das Gehäuse 13 in einer Oberseite 25 ein Kontrollfenster 26 auf, welches eine visuelle Kontrolle des Status der Sicherung 11 bzw. 12 erlaubt. Somit kann ein Wartungstechniker, ohne die Oberseite 25 zu entfernen, den Status unmittelbar kontrollieren bzw. überwachen. Weiter weist das Schienenfahrzeug zumindest einen hier nicht dargestellten passiven RFID-Transponder auf, mittels dessen der Status der Sicherung 11 bzw. 12 an eine hier gleichfalls nicht gezeigte Sender-Empfänger-Einheit übermittelbar ist. Dabei ist der RFID-Transponder innerhalb des Gehäuses 13 an der Sicherung 11 bzw. 12 angeordnet und mit dieser mechanisch gekoppelt. Dazu ist vorgesehen, dass der Stift 17 bzw. 18 beim Auslösen der Sicherung 11 bzw. 12 einen hier nicht zu sehenden Schalter eines hier nicht gezeigten Antennenstromkreises des RFID-Transponders betätigt, so dass der RFID-Transponder ein von der Sender-Empfänger-Einheit erzeugtes elektromagnetisches Wechselfeld empfängt, wodurch der RFID-Transponder aktiviert und ausgelesen wird.

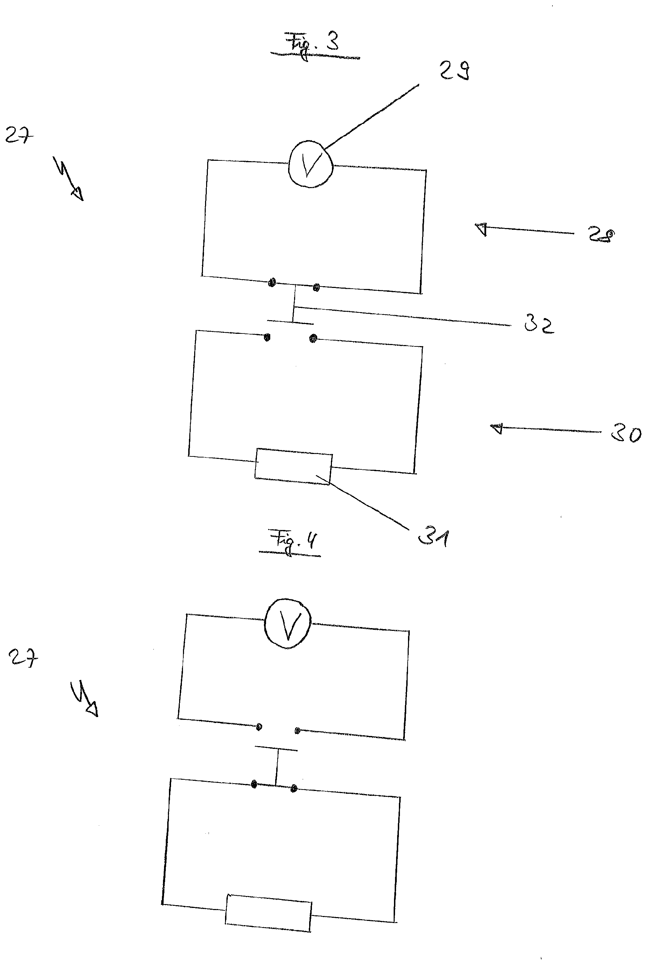

Eine Zusammenschau der Fig. 3 und 4 zeigt eine Prinzipdarstellung eines Überwachungssystems 27 in einer Ausführungsform. Zu sehen sind ein Verbraucherstromkreis 28 zur Versorgung von elektrischen Verbrauchern 29 eines hier nicht gezeigten Schienenfahrzeugs mit elektrischer Energie sowie ein Antennenstromkreis 30 zur Versorgung eines passiven RFID-Transponders 31 mit elektrischer Energie. Ferner ist ein Kurzschlussbügel 32 gezeigt, der beispielsweise durch die in den **Fig. 1** und **2** dargestellten Stifte 17 bzw. 18 ausgebildet sein kann, mittels dessen der Verbraucherstromkreis 28 oder der Antennenstromkreis 30 schließbar ist. Die **Fig. 3** zeigt das Überwachungssystem 27, bei welchem sich eine hier nicht gezeigte Hochspannungs-Sicherung in einem nicht ausgelösten Status befindet. Der Verbraucherstromkreis 28 ist geschlossen, der Antennenstromkreis 30 ist geöffnet. Beim Auslösen der Sicherung wird der Verbraucherstromkreis 28 unterbrochen und der Antennenstromkreis 30 geschlossen, so dass der RFID-Transponder 31 ein von einer hier nicht dargestellten Sender-Empfänger-Einheit erzeugtes elektromagnetisches Wechselfeld empfangen kann, wodurch der RFID-Transponder 31 aktiviert und ausgelesen werden kann.

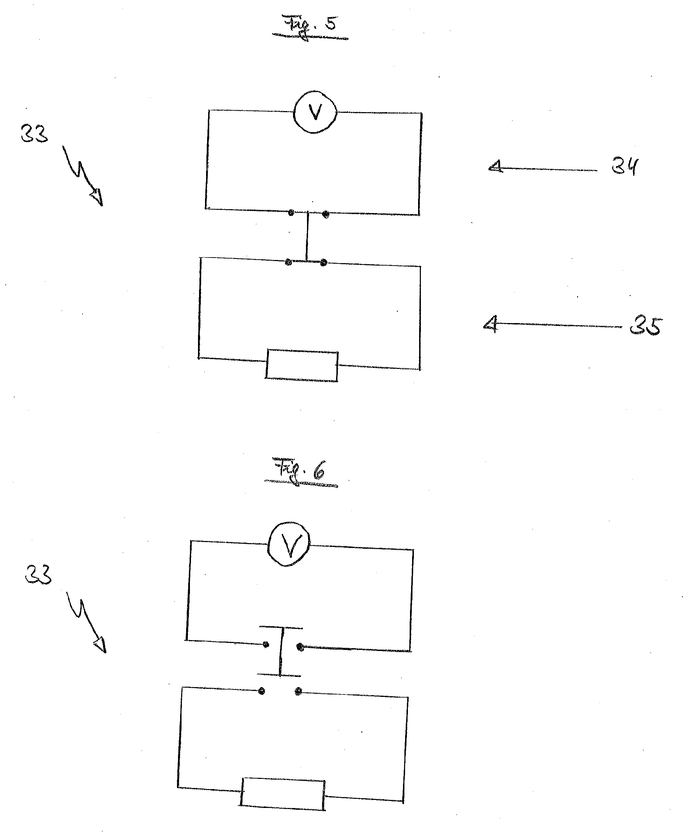

Eine Zusammenschau der **Fig. 5** und **6** zeigt eine Prinzipdarstellung eines Überwachungssystems 33 in einer weiteren Ausführungsform. Im Unterschied zu dem Überwachungssystem 27 sind hier in einem nicht ausgelösten Status sowohl ein Verbraucherstromkreis 34 als auch ein Antennenstromkreis 35 geschlossen. In einem ausgelösten Zustand sind sowohl der Verbraucherstromkreis 34 als auch der Antennenstromkreis 35 unterbrochen.

Die Beschreibung, die Zeichnungen und die Patentansprüche enthalten zahlreiche Merkmale in Kombination. Der Fachmann wird die Merkmale zweckmäßigerweise auch einzeln betrachten und zu sinnvollen weiteren Kombinationen zusammenfassen.

## Patentansprüche

1. Überwachungssystem, umfassend ein elektrisch angetriebenes Schienenfahrzeug mit einem Sicherungskasten (10) mit zumindest einer Hochspannungs-Sicherung (11, 12), wobei der Sicherungskasten ein gegenüber einer Umgebung geschlossenes Gehäuse (13) mit zumindest zwei Kabeleinführungen (14, 15, 16) aufweist, wobei durch die Kabeleinführungen verlaufende Hochspannungskabel des Schienenfahrzeuges mit der Sicherung verbunden sind,
**dadurch gekennzeichnet,**
**dass** das Schienenfahrzeug zumindest einen passiven RFID-Transponder (31) aufweist, wobei mittels des RFID-Transponders ein Status der Sicherung an eine Sender-Empfänger-Einheit übermittelbar ist, wobei die Sender-Empfänger-Einheit in einem Wartungsbereich zur Wartung des Schienenfahrzeugs ortsfest angeordnet ist.

2. Überwachungssystem nach Anspruch 1,
**dadurch gekennzeichnet,**
**dass** der RFID-Transponder (31) innerhalb des Gehäuses (13) an der Sicherung (11, 12) angeordnet ist.

3. Überwachungssystem nach Anspruch 1,
**dadurch gekennzeichnet,**
**dass** der RFID-Transponder (31) ein gegenüber einer Umgebung geschlossenes Gehäuse aufweist und neben dem Sicherungskasten (10) angeordnet ist.

4. Überwachungssystem nach einem der Ansprüche 1 bis 3,
**dadurch gekennzeichnet,**
**dass** das Überwachungssystem die Sender-Empfänger-Einheit umfasst.

5. Überwachungssystem nach einem der vorangehenden Ansprüche,
**dadurch gekennzeichnet,**
**dass** der Wartungsbereich außerhalb des Schienenfahrzeuges liegt.

6. Überwachungssystem nach Anspruch 5,
**dadurch gekennzeichnet,**
**dass** die Sender-Empfänger-Einheit in einem Einfahrtsabschnitt des Wartungsbereiches angeordnet ist.

7. Überwachungssystem nach einem der Ansprüche 1 bis 4,
**dadurch gekennzeichnet,**
**dass** der Wartungsbereich innerhalb des Schienenfahrzeuges liegt.

8. Überwachungssystem nach einem der vorangehenden Ansprüche,
**dadurch gekennzeichnet,**
**dass** das Überwachungssystem ein mobil handhabbares Anzeigegerät und/oder ein mobil handhabbares Bediengerät umfasst.

9. Überwachungssystem nach einem der vorangehenden Ansprüche,
**dadurch gekennzeichnet,**
**dass** ausschließlich Hochspannungskabel durch die Kabeleinführungen (14, 15, 16) verlaufen.

10. Überwachungssystem nach einem der vorangehenden Ansprüche,
**dadurch gekennzeichnet,**
**dass** als Sicherung (11, 12) ein Leitungsschutzschalter vorgesehen ist.

11. Überwachungssystem nach Anspruch 10,
**dadurch gekennzeichnet,**
**dass** der Leitungsschutzschalter einen Stift aufweist (17, 18), welcher in Richtung einer Längsachse des Stifts derart bewegbar ausgebildet ist, dass der Status durch eine Position einer Oberseite (19, 20) des Stiftes relativ zu einer Oberseite (21, 22) eines Gehäuses (23, 24) der Sicherung (11, 12) anzeigbar ist.

12. Überwachungssystem nach einem der vorangehenden Ansprüche,
**dadurch gekennzeichnet,**
**dass** das Gehäuse (13) in einer Oberseite (25) ein Kontrollfenster (26) aufweist, welches eine visuelle Kontrolle des Status erlaubt.

13. Überwachungssystem nach einem der vorangehenden Ansprüche,
**dadurch gekennzeichnet,**
**dass** eine an den Hochspannungskabeln anlegbare Hochspannung in einem Bereich von 500 - 2000 V liegt.

14. Überwachungssystem nach einem der vorangehenden Ansprüche,
**dadurch gekennzeichnet,**
**dass** eine Auslösestromstärke der Sicherung (11, 12) in einem Bereich von 500 - 2000 A liegt.

15. Überwachungssystem nach einem der vorangehenden Ansprüche,
**dadurch gekennzeichnet,**
**dass** die Sicherung (11, 12) mechanisch mit dem RFID-Transponder (31) gekoppelt ist, wobei die Sicherung einen Kurzschlussbügel (32) aufweist mittels dessen ein Verbraucherstromkreis (28, 34) zur Versorgung von elektrischen Verbrauchern (29) des Schienenfahrzeuges mit elektrischer Energie und/oder ein Antennenstromkreis (30, 35) zur Versorgung des RFID-Transponders (31) mit elektrischer Energie schließbar ist.

16. Überwachungssystem nach Anspruch 15,
**dadurch gekennzeichnet,**
**dass** die Sicherung (11, 12) mittels eines Hebelelements mit dem RFID-Transponder (31) gekoppelt ist.

17. Verfahren zur Überwachung von zumindest einer Hochspannungs-Sicherung (11, 12) eines Sicherungskastens (10) eines elektrisch angetriebenen Schienenfahrzeugs eines Überwachungssystems mittels des Überwachungssystems, wobei durch zumindest zwei Kabeleinführungen (14, 15, 16) eines gegenüber einer Umgebung geschlossenen Gehäuses (13) des Sicherungskastens verlaufende Hochspannungskabel des Schienenfahrzeuges mit der Sicherung verbunden werden,
**dadurch gekennzeichnet,**
**dass** mittels zumindest eines passiven RFID-Transponders (31) des Schienenfahrzeugs ein Status der Sicherung an eine Sender-Empfänger-Einheit des Überwachungssystems übermittelt wird, wobei die Sender-Empfänger-Einheit in einem Wartungsbereich zur Wartung des Schienenfahrzeugs ortsfest angeordnet wird.

18. Verfahren nach Anspruch 17,
**dadurch gekennzeichnet,**
**dass** die Sender-Empfänger-Einheit ein elektromagnetisches Wechselfeld erzeugt, welches von dem RFID-Transponder (31) empfangen wird, wodurch der RFID-Transponder aktiviert wird.

19. Verfahren nach Anspruch 18,
**dadurch gekennzeichnet,**
**dass** bevorzugt ein hochfrequentes (HF), besonders bevorzugt ein ultrahochfrequentes (UHF) Wechselfeld erzeugt wird.

20. Verfahren nach einem der Ansprüche 17 bis 19,
**dadurch gekennzeichnet,**
**dass** mittels eines Anzeigegerätes der Sender-Empfänger-Einheit und/oder des Sicherungskastens (10) der Status angezeigt wird.

21. Verfahren nach einem der Ansprüche 17 bis 20,
**dadurch gekennzeichnet,**
**dass** das Schienenfahrzeug relativ zu der Sender-Empfänger-Einheit bewegt wird.

22. Verfahren nach einem der Ansprüche 17 bis 21,
**dadurch gekennzeichnet,**
**dass** ein Wartungshinweis für die Sicherung (11, 12) übermittelt wird.
